# EUROPEAN PATENT SPECIFICATION

(11) **EP 3 958 403 B1**
(45) Date of publication and mention of the grant of the patent: **10.05.2023**
(21) Application number: 21181023.9
(22) Date of filing: 23.06.2021
(51) Int. Cl.: H01R 13/00

(54) **NETWORK COMMUNICATION DEVICE SET AND TRANSFORMER**
NETZWERKKOMMUNIKATIONSVORRICHTUNGSSATZ UND TRANSFORMATOR
ENSEMBLE DE DISPOSITIF DE COMMUNICATION DE RÉSEAU ET TRANSFORMATEUR

(30) Priority: 19.08.2020 CN 202010838600
(43) Date of publication of application: 23.02.2022
(73) Proprietor: Sernet (Suzhou) Technologies Corporation, Suzhou, Jiangsu (CN); Sercomm Corporation, Nangkang T'ai pei 115 (TW)
(72) Inventor: HO, Lili, 115 Taipei (TW)
(74) Representative: Becker, Eberhard

(56) References cited:
- CN-U- 204 104 147
- KR-B1- 101 790 779

## Description

### BACKGROUND

### Technical Field

The disclosure relates to a network communication device set and transformer, and in particular to a network communication device set and a transformer for supporting a network communication device.

### Description of Related Art

With the advancement of network technology, various network communication devices are more widely used in lives of people. The network communication devices usually need to be connected to power for operation, and stands also need to be disposed for the network communication devices to be placed stably. However, various accessories such as wires, transformers, and stands increase the cost of the network communication devices and are difficult to keep.

CN 204 104 147 U discloses a wireless AP being provided with a detachable plug, including: a wireless AP body, a power plug, a wireless AP body with a network jack and a USB interface on one of the end surfaces; a power plug with two pins on one of the ends; a wireless AP body with a sunken seat on one of the surfaces, and a USB plug perpendicular to the bottom surface of the sunken seat; the other end of the power plug has a USB interface combined with the USB plug on the wireless AP body. The other end of the power plug is provided with a USB interface combined with the USB plug set on the body of the wireless AP.

### SUMMARY

The present invention is provided by the appended claims. The following disclosure serves a better understanding of the present invention. The disclosure provides a network communication device set and a transformer. A network communication device may be supported by the transformer.

According to an embodiment of the disclosure, the network communication device set includes the network communication device and a transformer as described below.

According to an embodiment of the disclosure, a transformer has a power output terminal and a second power input terminal. The second power input terminal is configured to plug into a socket. The power output terminal is located on a top surface of transformer. When a part of the transformer is detachably assembled in the accommodating groove of the network communication device, a first power input terminal of the network communication device is connected to the power output terminal, and the top surface of transformer is configured to contact a groove surface of the accommodating groove to support the network communication device. The transformer further has a pair of guiding grooves, and when a part of the transformer is detachably assembled in the accommodating groove, a pair of guiding members of the groove surface are integrated in the guiding grooves, the guiding grooves are located on the top surface of the transformer, and the guiding grooves are located on two sides of the power output terminal.

In an embodiment of the disclosure, the transformer further has an engagement member. The groove surface of the accommodating groove has an engagement hole. When the part of transformer is detachably assembled in the accommodating groove, the engagement member is engaged into the engagement hole.

In an embodiment of the disclosure, the engagement member is located on the top surface of the transformer and surrounds the power output terminal.

In an embodiment of the disclosure, the engagement member is C-shaped.

In an embodiment of the disclosure, the second power input terminal is configured to receive an alternating current. The power output terminal is configured to output a direct current.

In an embodiment of the disclosure, the transformer further has a boss for engaging into holes of the socket. The second power input terminal is located at the boss.

In an embodiment of the disclosure, a connection orientation of the first power input terminal and the power output terminal is perpendicular to a connection orientation of the second power input terminal and the socket.

Based on the above, in the network communication device set and the transformer of the disclosure, the transformer may be configured to support the network communication device. Therefore, the number of accessories may be reduced and the network communication device can be placed stably.

### BRIEF DESCRIPTION OF THE DRAWINGS

FIG. 1 is a schematic diagram of a network communication device set according to an embodiment of the disclosure.
FIG. 2 is a schematic diagram of a network communication device of the network communication device set in FIG. 1.
FIG. 3 is a schematic diagram of a transformer of the network communication device set in FIG. 1.

### DETAILED DESCRIPTION OF DISCLOSED EMBODIMENTS

Reference will now be made in detail to the exemplary embodiments of the disclosure, and examples of the exemplary embodiments are illustrated in the accompanying drawings. Whenever possible, the same reference numerals are used in the drawings and the description to indicate the same or similar parts.

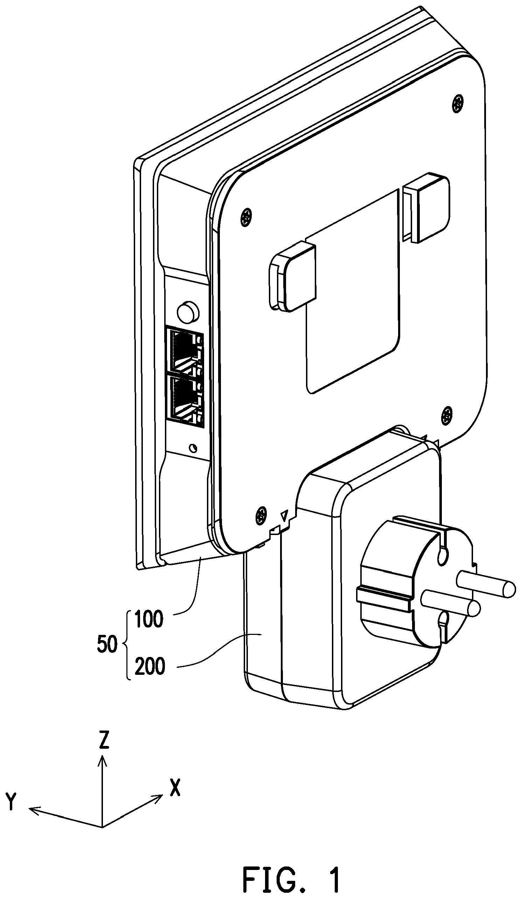

FIG. 1 is a schematic diagram of a network communication device set according to an embodiment of the disclosure. Please refer to FIG. 1, a network communication device set 50 of the embodiment includes a network communication device 100 and a transformer 200. The transformer 200 may be electrically connected to the network communication device 100 and configured to provide the power required by the network communication device 100 during operation.

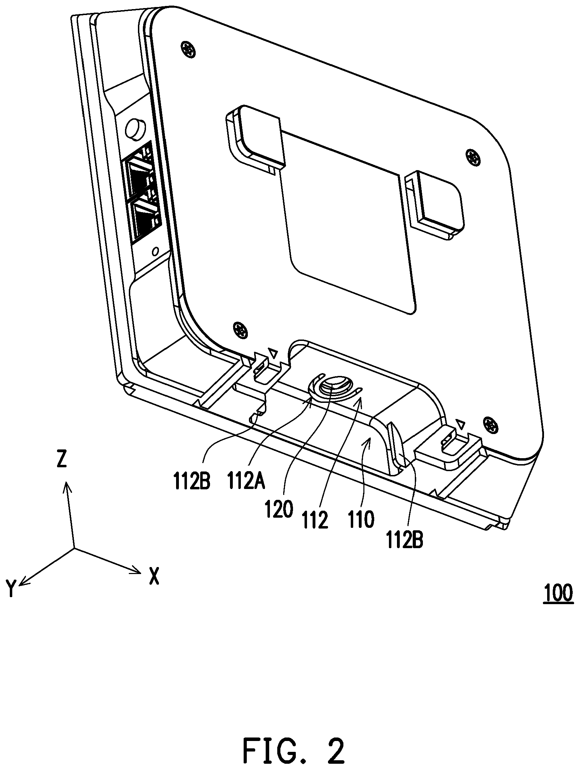

FIG. 2 is a schematic diagram of a network communication device of the network communication device set in FIG. 1. Please refer to FIG. 2, the network communication device 100 of the embodiment has an accommodating groove 110 and a first power input terminal 120. The first power input terminal 120 is located in the accommodating groove 110.

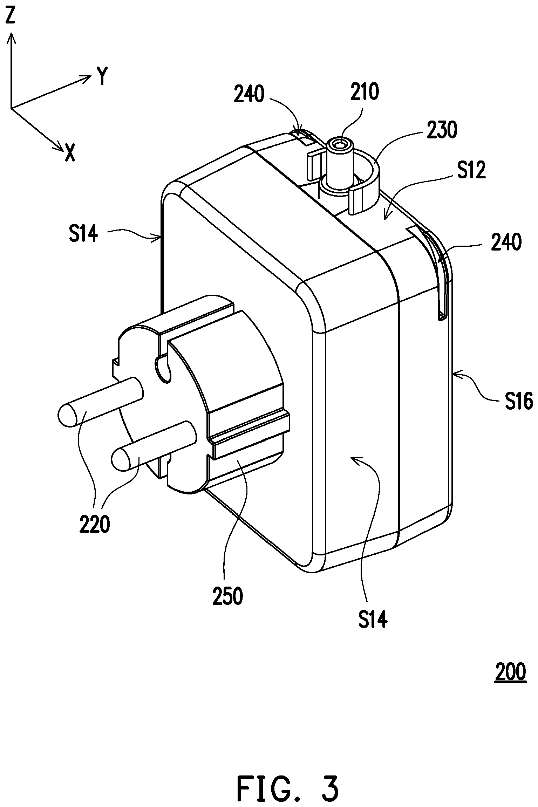

FIG. 3 is a schematic diagram of a transformer of the network communication device set in FIG. 1. Please refer to FIG. 3, a transformer 200 of the embodiment has a power output terminal 210 and a second power input terminal 220. The second power input terminal 220 is configured to plug into a socket (not shown). In other words, the second power input terminal 220 may be connected to the supply mains via the socket. The power output terminal 210 is located on a top surface S12 of the transformer 200. The top surface S12 refers to a surface on a top part of the transformer 200 when the second power input terminal 220 is inserted into the socket in the recommended orientation.

Please refer to FIG. 1 to FIG. 3, when a part of the transformer 200 is detachably assembled in the accommodating groove 110 of the network communication device 100, the first power input terminal 120 is connected to the power output terminal 210. Therefore, the supply mains input from the second power input terminal 220 may be output from the power output terminal 210 to the first power input terminal 120 after being converted by the transformer 200, so as to provide the power required by the network communication device 100 during operation. In addition, the top surface S12 of the transformer 200 is configured to contact a groove surface 112 of the accommodating groove 110 to support the network communication device 100.

It can be seen from the above that through the integration of the accommodating groove 110 of the network communication device 100 and a part of the transformer 200, the network communication device 100 may be supported on top of the transformer 200 by the transformer 200. Therefore, the network communication device 100 may be placed stably without requiring an additional support base or wall mount. In addition, when the transformer 200 is integrated with the network communication device 100, the power required for the network communication device 100 to operate is also provided. Therefore, the number of accessories of the network communication device set 50 of the embodiment may be reduced to save the cost and avoid the trouble of storing accessories.

The network communication device of the embodiment is, for example, a home gateway and a mesh wireless relay that support smart speakers, a wireless access point that uses a 6GHz unlicensed spectrum, an XGS-PON home gateway that supports 4*4 11ax WiFi, and a set-top box that supports decoding and hybrid.

For example, when a part of transformer 200 is assembled in the accommodating groove 110 of the network communication device 100, in addition to the top surface S12 of the transformer 200 contacting the groove surface 112 of the accommodating groove 110, two side surfaces S14 and a front surface S16 of the transformer 200 are also contacting the accommodating groove 110. Therefore, the contact between the top surface S12 and the accommodating groove 110 may support the network communication device 100 in the Z orientation, the contact between the two side surfaces S14 and the accommodating groove 110 may restrict the movement of the network communication device 100 in the X orientation, and the contact between the front surface S16 and the accommodating groove 110 and the connection of the first power input terminal 120 and the power output terminal 210 may restrict the movement of the network communication device 100 in the Y orientation. In other words, the integration of the transformer 200 and the network communication device 100 enables the network communication device 100 to be positioned firmly on the transformer 200.

In the embodiment, the transformer 200, for example, further has an engagement member 230. The groove surface 112 of the accommodating groove 110 has an engagement hole 112A. When a part of the transformer 200 is detachably assembled in the accommodating groove 110, the engagement member 230 is engaged into the engagement hole 112A. Therefore, the transformer 200 and the network communication device 100 may be integrated more firmly. The engagement member 230 of the embodiment is, for example, located on the top surface S12 of the transformer 200 and surrounds the power output terminal 210. The engagement member 230 may also provide proper protection for the power output terminal 210. The engagement member 230 of the embodiment is, for example, C-shaped, but the disclosure is not limited thereto.

According to the invention, the transformer 200 further has a pair of guiding grooves 240. The groove surface 112 of the accommodating groove 110 has a pair of guiding members 112B. When a part of the transformer 200 is detachably assembled in the accommodating groove 110, the guiding members 112B are integrated in the guiding grooves 240. Therefore, the transformer 200 and the network communication device 100 may be integrated more firmly. In addition, the integration of the guiding grooves 240 and the guiding members 112B may also serve the function of guiding orientation/foolproof during the process of integrating the transformer 200 and the network communication device 100. The guiding grooves 240 of the embodiment are located on the top surface S12 of the transformer 200, and the guiding grooves 240 are located on two sides of the power output terminal 210.

The second power input terminal 220 of the embodiment is, for example, configured to receive an alternating current, and the power output terminal 210 is, for example, configured to output a direct current.

The transformer 200 of the embodiment, for example, further has a boss 250 for engaging into holes (not shown) of the socket. The second power input terminal 220 is located at the boss 250. Due to the engagement of the boss 250 and the holes of the socket, the network communication device 100 may be fixed more firmly on a wall configured with the socket through the transformer 200. The boss 250 extends from the transformer 200 toward the -Y orientation, and the second power input terminal 220 then extends from the boss 250 toward the -Y orientation.

In the embodiment, a connection orientation of the first power input terminal 120 and the power output terminal 210 is the Z orientation, a connection orientation of the second power input terminal 220 and the socket is the Y orientation, and the two are perpendicular to each other. In other words, when the transformer 200 is horizontally inserted into the socket, the network communication device 100 is integrated with the transformer 200 in the Z orientation and is supported.

In summary, in the network communication device set and the transformer of the disclosure, a part of transformer may be assembled in the accommodating groove to support the network communication device. Therefore, the number of accessories may be reduced and the network communication device can be placed stably.

### [Description of the Reference Signs]

50: network communication device set
100: network communication device
110: accommodating groove
112: groove surface
112A: engagement hole
112B: guiding member
120: first power input terminal
200: transformer
210: power output terminal
220: second power input terminal
230: engagement member
240: guiding groove
250: boss
S12: top surface
S14: side surface
S16: front surface

## Claims

1. A transformer (200), having a power output terminal (210) and a second power input terminal (220), wherein the second power input terminal (220) is configured to plug into a socket, the power output terminal (210) is located on a top surface (S12) of the transformer (200), when a part of the transformer (200) is detachably assembled in an accommodating groove (110) of a network communication device (100), a first power input terminal (120) of the network communication device (100) is connected to the power output terminal (210), the top surface (S12) of the transformer (200) is configured to contact a groove surface (112) of the accommodating groove (110) to support the network communication device (100), and a connection orientation of the first power input terminal (120) and the power output terminal (210) is perpendicular to a connection orientation of the second power input terminal (220) and the socket, the transformer (200) being **characterized by**
further having a pair of guiding grooves (240), and when a part of the transformer (200) is detachably assembled in the accommodating groove (110), a pair of guiding members (112B) of the groove surface (112) are integrated in the guiding grooves (240), the guiding grooves (240) are located on the top surface (S12) of the transformer (200), and the guiding grooves (240) are located on two sides of the power output terminal (210).

2. The transformer (200) according to claim 1, **characterized by** further having an engagement member (230), wherein the groove surface (112) of the accommodating groove (110) has an engagement hole (112A), when a part of the transformer (200) is detachably assembled in the accommodating groove (110), the engagement member (230) is engaged into the engagement hole (112A), the engagement member (230) is located on the top surface (S12) of the transformer (200) and surrounds the power output terminal (210), and the engagement member (230) is C-shaped.

3. The transformer (200) according to claim 1, **characterized in that** the second power input terminal (220) is configured to receive an alternating current, the power output terminal (210) is configured to output a direct current, the transformer (200) further has a boss (250) for engaging into holes of the socket, and the second power input terminal (220) is located at the boss (250).

4. The transformer (200) according to claim 1, **characterized in that** a connection orientation of the first power input terminal (120) and the power output terminal (210) is perpendicular to a connection orientation of the second power input terminal (220) and the socket.

5. A network communication device set (50), **characterized by** comprising:
a network communication device (100), having an accommodating groove (110) and a first power input terminal (120), wherein the first power input terminal (120) is located in the accommodating groove (110); and
the transformer (200) according to anyone of claims 1-4.

## Patentansprüche

1. Transformator (200), aufweisend einen Energieausgangsanschluss (210) und einen zweiten Energieeingangsanschluss (220), wobei der zweite Energieeingangsanschluss (220) konfiguriert ist, um in eine Steckdose eingesteckt zu werden, wobei der Energieausgangsanschluss (210) sich auf einer oberen Fläche (S12) des Transformators (200) befindet, wobei, wenn ein Teil des Transformators (200) lösbar in einer Aufnahmenut (110) einer Netzwerkkommunikationsvorrichtung (100) montiert ist, ein erster Energieeingangsanschluss (120) der Netzwerkkommunikationsvorrichtung (100) mit dem Energieausgangsanschluss (210) verbunden ist, die obere Fläche (S12) des Transformators (200) konfiguriert ist, um eine Nutfläche (112) der Aufnahmenut (110) zu berühren, um die Netzwerkkommunikationsvorrichtung (100) zu stützen, und eine Verbindungsausrichtung des ersten Energieeingangsanschlusses (120) und des Energieausgangsanschlusses (210) senkrecht zu einer Verbindungsausrichtung des zweiten Energieeingangsanschlusses (220) und der Steckdose ist, wobei der Transformator (200) **gekennzeichnet ist durch**
ferner Aufweisen eines Paars von Führungsnuten (240), und wenn ein Teil des Transformators (200) lösbar in der Aufnahmenut (110) montiert ist, ein Paar von Führungselementen (112B) der Nutfläche (112) in die Führungsnuten (240) integriert ist, wobei die Führungsnuten (240) sich auf der oberen Fläche (S12) des Transformators (200) befinden und die Führungsnuten (240) sich auf zwei Seiten des Energieausgangsanschlusses (210) befinden.

2. Transformator (200) gemäß Anspruch 1, **dadurch gekennzeichnet, dass** er ferner ein Eingriffselement (230) aufweist, wobei die Nutfläche (112) der Aufnahmenut (110) ein Eingriffsloch (112A) aufweist, wenn ein Teil des Transformators (200) lösbar in der Aufnahmenut (110) montiert ist, das Eingriffselement (230) in das Eingriffsloch (112A) eingreift, das Eingriffselement (230) sich auf der oberen Fläche (S12) des Transformators (200) befindet und den Energieausgangsanschluss (210) umgibt und das Eingriffselement (230) C-förmig ist.

3. Transformator (200) gemäß Anspruch 1, **dadurch gekennzeichnet, dass** der zweite Energieeingangsanschluss (220) konfiguriert ist, um einen Wechselstrom zu empfangen, der Energieausgangsanschluss (210) konfiguriert ist, um einen Gleichstrom auszugeben, der Transformator (200) ferner einen Vorsprung (250) zum Eingreifen in Löcher der Steckdose aufweist und sich der zweite Energieeingangsanschluss (220) an dem Vorsprung (250) befindet.

4. Transformator (200) gemäß Anspruch 1, **dadurch gekennzeichnet, dass** eine Verbindungsausrichtung des ersten Energieeingangsanschlusses (120) und des Energieausgangsanschlusses (210) senkrecht zu einer Verbindungsausrichtung des zweiten Energieeingangsanschlusses (220) und der Steckdose ist.

5. Netzwerk-Kommunikationsvorrichtungsset (50), **dadurch gekennzeichnet, dass** es umfasst:
eine Netzwerkkommunikationsvorrichtung (100), die eine Aufnahmenut (110) und einen ersten Energieeingangsanschluss (120) aufweist, wobei sich der erste Energieeingangsanschluss (120) in der Aufnahmenut (110) befindet; und
den Transformator (200) gemäß einem der Ansprüche 1-4.

## Revendications

1. Transformateur (200), ayant une borne de sortie de puissance (210) et une deuxième borne d'entrée de puissance (220), dans lequel la deuxième borne d'entrée de puissance (220) est configurée pour se brancher à une prise, la borne de sortie de puissance (210) est située sur une surface supérieure (S12) du transformateur (200), lorsqu'une partie du transformateur (200) est assemblée, de manière détachable, dans une rainure d'accueil (110) d'un dispositif de communication de réseau (100), une première borne d'entrée de puissance (120) du dispositif de communication de réseau (100) est reliée à la borne de sortie de puissance (210), la surface supérieure (S12) du transformateur (200) est configurée pour venir au contact d'une surface de rainure (112) de la rainure d'accueil (110) pour supporter le dispositif de communication de réseau (100), et une orientation de liaison de la première borne d'entrée de puissance (120) et la borne de sortie de puissance (210) est perpendiculaire à une orientation de liaison de la deuxième borne d'entrée de puissance (220) et de la prise, le transformateur (200) étant **caractérisé en ce que**
il a en outre une paire de rainures de guidage (240), et, lorsqu'une partie du transformateur (200) est assemblée, de manière détachable, dans la rainure d'accueil (110), une paire d'éléments de guidage (112B) de la surface de rainure (112) sont intégrés dans les rainures de guidage (240), les rainures de guidage (240) sont situées sur la surface supérieure (S12) du transformateur (200), et les rainures de guidage (240) sont situées sur deux côtés de la borne de sortie de puissance (210).

2. Transformateur (200) selon la revendication 1, **caractérisé en ce qu'**il a en outre un élément d'engagement (230), dans lequel la surface de rainure (112) de la rainure d'accueil (110) a un trou d'engagement (112A), lorsqu'une partie du transformateur (200) est assemblée, de manière détachable, dans la rainure d'accueil (110), l'élément d'engagement (230) est engagé dans le trou d'engagement (112A), l'élément d'engagement (230) est situé sur la surface supérieure (S12) du transformateur (200) et entoure la borne de sortie de puissance (210), et l'élément d'engagement (230) est en forme de C.

3. Transformateur (200) selon la revendication 1, **caractérisé en ce que** la deuxième borne d'entrée de puissance (220) est configurée pour recevoir un courant alternatif, la borne de sortie de puissance (210) est configurée pour délivrer un courant continu, le transformateur (200) a en outre un bossage (250) pour s'engager dans des trous de la prise, et la deuxième borne d'entrée de puissance (220) est située au niveau du bossage (250).

4. Transformateur (200) selon la revendication 1, **caractérisé en ce qu'**une orientation de liaison de la première borne d'entrée de puissance (120) et de la borne de sortie de puissance (210) est perpendiculaire à une orientation de liaison de la deuxième borne d'entrée de puissance (220) et de la prise.

5. Ensemble de dispositif de communication de réseau (50), **caractérisé en ce qu'**il comprend :
un dispositif de communication de réseau (100), ayant une rainure d'accueil (110) et une première borne d'entrée de puissance (120), dans lequel la première borne d'entrée de puissance (120) est située dans la rainure d'accueil (110) ; et
le transformateur (200) selon l'une quelconque des revendications 1 à 4.
